# EUROPEAN PATENT APPLICATION

(11) **EP 4 786 247 A1**
(43) Date of publication of application: **05.08.2026**
(21) Application number: 26150733.9
(22) Date of filing: 08.01.2026
(51) Int. Cl.: B60L 3/12, B60K 35/20, B60K 35/28, B60L 58/10, B60L 58/12, B60L 58/16, B60L 58/18, G01R 31/367, G01R 31/382, G01R 31/392, G06F 18/00, G06N 3/08, G06N 20/00, H01M 10/42, H01M 10/48

(54) **BATTERY LIFE PREDICTION APPARATUS AND METHOD**

(30) Priority: 03.02.2025 KR 20250013405
(71) Applicant: SAMSUNG SDI CO., LTD., Yongin-si, Gyeonggi-do 17084 (KR)
(72) Inventor: AHN, Taesung, 17084 Yongin-si (KR); LEE, Changhyun, 17084 Yongin-si (KR); LEE, Hyeongmin, 17084 Yongin-si (KR); SEONG, Junghyun, 17084 Yongin-si (KR)
(74) Representative: Marks & Clerk LLP

(57) **Abstract**

An apparatus and method for predicting a life of a battery provided in an electric vehicle are described. A battery life prediction method includes generating, by a processor, field data through event-based profiling based on one or more detection results of voltage, current, and temperature collected from a battery; calculating, by the processor, a state of health (SOH) of the battery using the field data; extracting, by the processor, as log data, battery performance indicator data corresponding to an operating state of the battery from the field data; transmitting the log data to a server and collecting a life prediction value of the battery generated by the server based on the log data; and determining status related to the life of the battery based on comparing the SOH of the battery with the life prediction value of the battery; and performing an action with respect to the battery based on determining the status.

## Description

### BACKGROUND

### 1. Field

One or more aspects of embodiments of the present disclosure relate to an apparatus and method for predicting a life of a battery.

### 2. Description of the Related Art

A battery management system (BMS) of an electric vehicle generally monitors voltage, current, temperature, and/or the like, of a battery module, to estimate a state of health (SOH) and a remaining useful life (RUL) of the battery based on such data. However, it may be difficult for the BMS to precisely analyze changes in the battery's state over time due to, for example, limitations in real-time data processing and long-term data storage. The problem caused by limitations in data logging may make battery life prediction and optimized battery management difficult. The BMS may also not be able to reflect changes over time, such as hysteresis characteristics, and thus, prediction of the remaining life of the battery may be based on existing data. However, it may be difficult to accurately predict the remaining life of the battery merely with existing data.

The above-described information disclosed in the technology section that serves as the background of the disclosure is provided for improving the understanding of the background of the disclosure, and thus may include information that does not constitute related art.

### SUMMARY

One or more embodiments of the present disclosure provides using cloud-based data analysis technology to more accurately predict a state of health (SOH) and a remaining useful life (RUL) of a battery based on battery usage data collected from an external server.

However, technical problems to be solved by the disclosure are not limited to the problem, and other problems not mentioned may be clearly understood by those of ordinary skill in the art from the description of the disclosure described below.

According to an aspect of the disclosure, a battery life prediction method includes generating, by a processor, field data through event-based profiling based on one or more detection results of voltage, current, and temperature collected from a battery; calculating, by the processor, a state of health (SOH) of the battery using the field data; extracting, by the processor, as log data, battery performance indicator data corresponding to an operating state of the battery from the field data; transmitting, by the processor, the log data to a server and receiving a life prediction value of the battery generated by the server based on the log data; determining status related to the life of the battery based on comparing the SOH of the battery with the life prediction value of the battery; and performing an action with respect to the battery based on determining the status.

According to one aspect of the disclosure, a battery life prediction apparatus includes a processor and a memory operatively connected to the processor and storing at least one code to be executed by the processor, in which the memory stores a code causing, when executed through the processor, the processor to generate field data through event-based profiling based on one or more detection results of voltage, current, and temperature collected from a battery; calculate a state of health (SOH) of the battery using the field data; extract, as log data, battery performance indicator data corresponding to an operating state of the battery from the field data; transmit the log data to a server and receive a life prediction value of the battery generated by the cloud server based on the log data; determine status related to the life of the battery based on comparing the SOH of the battery with the life prediction value of the battery; and perform an action with respect to the battery based on determining the status.

In some embodiments, another method and another system for implementing the disclosure, and a computer-readable recording medium having stored therein a computer program for executing the method may be further provided.

Other aspects, features, advantages, and advantages other than those described above will become apparent from the following figures, claims, and the detailed description of the disclosure.

At least some of the above and other features of the invention are set out in the claims.

### BRIEF DESCRIPTION OF THE DRAWINGS

The following drawings attached to this specification illustrate one or more embodiments of the disclosure, and serve to further understand the technical idea of the disclosure together with the detailed description of the disclosure, such that the disclosure should not be construed as being limited to the matters shown in such drawings in which:
FIG. 1 depicts a block diagram of a computing environment for battery life prediction according to an embodiment of the disclosure;
FIG. 2 depicts a block diagram of a first processor provided in a battery management system (BMS) as a battery life prediction apparatus, according to an embodiment of the disclosure;
FIG. 3 depicts a table storing log data extracted from field data stored in a battery life prediction apparatus according to an embodiment of the disclosure is organized;
FIGS. 4A-4C depict graphs of a state of charge (SOC) of a battery over time for respectively first, second, and third scenario pattern templates for battery life prediction according to an embodiment of the disclosure;
FIG. 5 depicts a graph of a state of charge (SOC) of a battery over time for a driving scenario reconstructed using log data according to an embodiment of the disclosure;
FIGS. 6A-6B respectively depict graphs of a state of charge (SOC) of a battery over time for respectively a first case (e.g., a worst case) and a second case (e.g., a best case) among results of restoring an identified (e.g., a preset) number of reconstructed driving scenarios of an identified (e.g., a preset) period according to an embodiment of the disclosure;
FIGS. 7 and 8 are examples of graphs comparing a state of health (SOH) of a battery and a life prediction value of the battery according to an embodiment of the disclosure; and
FIG. 9 is a flowchart of a battery life prediction method according to an embodiment of the disclosure.

### DETAILED DESCRIPTION

Hereinafter, embodiments of the disclosure will be described in detail with reference to the accompanying drawings. The terms and words used in the present specification and claims described above should not be construed as being limited to ordinary or dictionary meanings, and should be interpreted as meanings and concepts consistent with the technical idea of the disclosure based on the principle that the present inventors may be his/her own lexicographer to appropriately define the concept of the terms to describe their invention in the best way. Therefore, the embodiments described in this specification and the configurations illustrated in the drawings are only some of the embodiments of the disclosure and do not represent all of the technical ideas, aspects, and features of the disclosure, and it should be understood that there may be various equivalents and modified examples that can replace or modify the embodiments at the time of filing this application.

As used herein, "comprise, include" and/or "comprising, including" specify mentioned shapes, numbers, steps, operations, members, components, and/or presence of these groups, and do not exclude the presence or addition of one or more different shapes, numbers, operations, members, components, and /or groups. When embodiments of the disclosure are described, "can" or "may" may include "one or more embodiments of the disclosure".

To help understanding of the disclosure, the accompanying drawings are not shown according to the actual scale, but the dimensions of some components may be exaggerated. The same reference numeral may be given to the same component in different embodiments.

The statement that two comparison targets are "the same" as each other may mean that they are "substantially the same" as each other. Thus, a case where they are "substantially the same" as each other may include a case where they have a deviation regarded as a low level, e.g., a deviation of 5 % or less. In case that a uniform parameter is uniform in a predetermined area, it may mean that it is uniform from an average point of view.

Although first, second, etc., may be used to describe various components, these components are not limited by these terms. These terms are only used to distinguish one component from other components, and unless specifically stated to the contrary, a first component may be a second component.

Throughout the specification, unless specially stated to the contrary, each component may be singular or plural.

In case that a component is arranged on "a top portion (or a bottom portion)" of another component or "on (or under)" the other component, it may mean not only a case where the component is arranged adjacent to a top surface (or a bottom surface) of the other component, but also a case where another component may be interposed between the other component and the component arranged on (or under) the other component.

In case that a component is described as being "connected", "coupled", or "connected" to another component, it should be understood that the components are directly connected or connectable to each other, but another component may be "interposed" between the components, or the components may be "connected", "coupled", or "connected" to each other through another component. In case that a portion is electrically coupled to another portion, this may include not only a case where they are directly connected to each other, but also a case where they are connected with another element therebetween.

Throughout the specification, "A and/or B" may mean A, B, or A and B unless specially stated otherwise. That is, "and/or" may include all or any combination of a plurality of items listed. "C to D" may mean at least C but not more than D, unless specially stated otherwise.

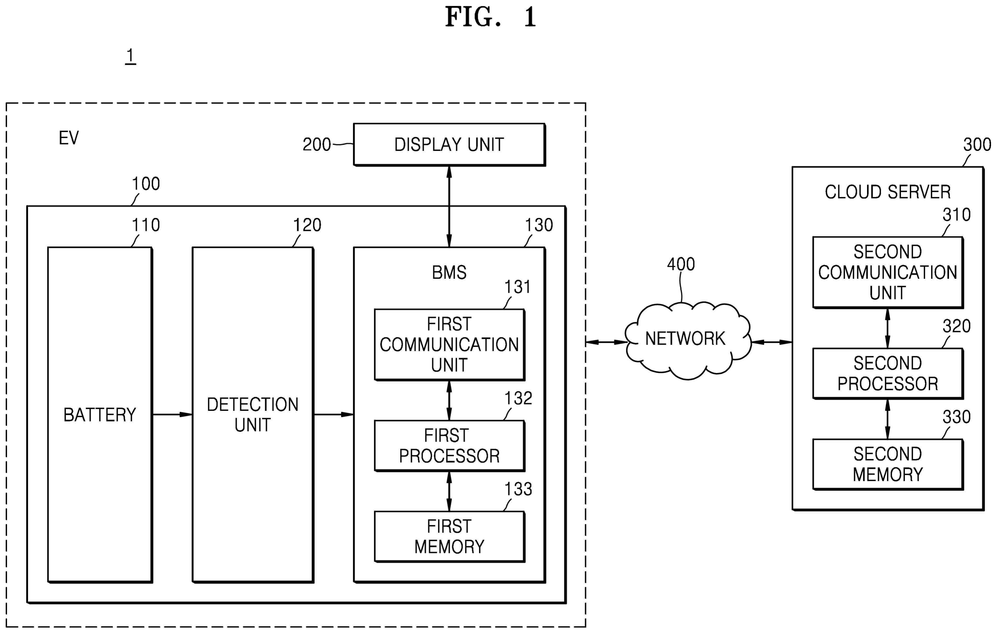

FIG. 1 depicts a block diagram of a computing environment or system for battery life prediction according to an embodiment of the disclosure. Referring to FIG. 1, the computing environment 1 may include a battery system 100, a display unit 200, a server (e.g., cloud server) 300, and a network 400. In one embodiment, the battery system 100 and the display unit 200 may be provided in an electric vehicle (EV).

In one embodiment, the battery system 100 may include a battery 110, a detection unit 120, and a battery management system (BMS) 130.

The battery 110 may be used as a main power source for the EV. The battery 110 may provide high energy density, long life, and charging efficiency, which may affect mileage and performance of the EV.

The battery 110 may include a secondary battery other than rechargeable lead-acid batteries. For example, the battery 110 may include a nickel-cadmium battery, a nickel metal hydride battery (NiMH), a lithium ion battery, a lithium polymer battery, and/or the like

In one embodiment, the battery 110 may include a battery cell (not shown), a battery module (not shown), and a battery pack (not shown). A battery cell may be a basic unit of the battery and may mean one electrochemical cell. A battery module may include several battery cells electrically connected to form a single unit. A battery pack may include multiple battery modules combined into a larger unit.

In one embodiment, the term "battery" may be interpreted in various ways depending on the context in which the battery is used. The term "battery" may refer to a single battery cell, a battery module formed by assembling battery cells, or a battery pack formed by combining multiple modules, individually or collectively. Therefore, the "battery" mentioned below may refer to one of a battery cell, a battery module, and a battery pack, depending on the context, and sometimes may mean including all of these components.

The detection unit 120 may detect a status of cells constituting the battery 110 based on a signal received from the battery 110. A signal detected by the detection unit 120 from the battery 110 may include at least one of a voltage measurement signal indicating a voltage across opposite ends of cells constituting the battery 110, a current measurement signal indicating current flowing in the battery 110, and/or a temperature measurement signal indicating a temperature of the battery 110. In some embodiments, the detection unit 120 includes a multimeter, temperature sensor, and/or other sensor for sensing the status of the battery 110.

Hereinafter, one or more of the voltage, current, and temperature detected by the detection unit 120 will be referred to as detection data. The detection data may be generated based on detecting a preset or monitored event. For example, the preset event may include the arrival of a time according to a selected cycle, switching of the battery 110 to a charging state, switching of the battery 110 to a discharging state, switching of the battery 110 to a rest state, the start of charging of the battery 110, the elapse of a selected time after the start of charging of the battery 110, and/or the like.

The BMS 130 may monitor and control one or more of charging and discharging of the battery 110 to optimize or control the performance of the battery 110. In one embodiment, the BMS 130 may perform the following additional functions as well as the function of monitoring and controlling one or more of charging and discharging of the battery 110.

The BMS 130 may calculate a state of health (SOH) of the battery 110 based on the detection data of the battery 110 received from the detection unit 120. The BMS 130 may transmit log data generated based on the detection data of the battery 110 to the cloud server 300, and the cloud server 300 may collect or identify a life prediction value of the battery 110 generated based on the log data from the cloud server 300. The BMS 130 may determine whether the life of the battery 110 is abnormal, by comparing the SOH of the battery 110 with the life prediction value of the battery 110. The BMS 130 may calculate a remaining useful life (RUL) of the battery 110 based on the SOH of the battery 110 and the life prediction value of the battery 110. The BMS 130 may output a result of determining whether the life of the battery 110 is abnormal and the result of calculating one or more of the RULs of the battery 110 to the display unit 200. Based on the output, actions may be taken with respect to the battery, such as, for example, replacing the battery, repurposing the battery for other uses (e.g., stationary energy storage), and/or the like. The actions that may be taken with respect to the battery include outputting an indication of the operating conditions of the battery, including presenting an alert message to the user indicating that the battery is abnormal or indicating the RUL of the battery. The actions that may be taken with respect of the battery may also include generating an instruction with respect to the operation of the battery, including turning off the battery or instructing the battery to enter a rest state.

In one embodiment, the BMS 130 may serve as a battery life prediction apparatus. The phrase battery life prediction apparatus and BMS 130 may be used interchangeably herein. In some embodiments, the BMS 130 is configured to effectively use data analysis technology to predict and optimize (or control) the life of the battery 110 beyond the function of simply monitoring and controlling one or more of charging and discharging.

In one embodiment, the BMS 130 may include a first communication unit 131, a first processor 132, and a first memory 133.

The first communication unit 131, along with the network 400, may provide a communication interface to provide transmission and reception signals between the battery system 100 and the cloud server 300 in the form of packet data. In some embodiments, the communication interface refers to a medium which connects the battery system 100 to the cloud server 300, and may include a path which provides a connection path enabling the battery system 100 to transmit and receive information after accessing the cloud server 300. The first communication unit 131 may be a device including hardware and software configured to transmit and receive signals, such as control signals or data signals, through wired or wireless connection to and from other network devices.

The first processor 132 may process functions performed by the BMS 130. The first processor 132 may process a command of a computer program by performing basic arithmetic, logic, and input/output operations. For example, the first processor 132 may be implemented as an array of multiple logic gates, or may be implemented as a combination of a general-purpose microprocessor and a memory storing a program executable on the microprocessor. For example, a processor may include a general purpose processor, a central processing unit (CPU), a microprocessor, a digital signal processor (DSP), a controller, a microcontroller, a state machine, and/or the like. In some environments, the first processor 132 may include an application specific integrated circuit (ASIC), a programmable logic device (PLD), a field programmable gate array (FPGA), and/or the like. For example, the first processor 132 may refer to a combination of a DSP and a microprocessor, a combination of a plurality of microprocessors, a combination of one or more microprocessors combined with a DSP core, or a combination of processing devices such as any combination of other such components.

The first memory 133 may be operably connected to the first processor 132 and may store at least one code associated with an operation performed by the first processor 132.

The first memory 133 may perform a function to temporarily or permanently store data processed by the first processor 132. In some embodiments, the first memory 133 may include a magnetic storage medium or a flash storage medium, but the scope of the disclosure is not limited thereto. The first memory 133 may include internal memory and/or external memory, and may include volatile memory such as DRAM, SRAM, or SDRAM, nonvolatile memory such as OTPROM, PROM, EPROM, EEPROM, mask ROM, flash ROM, NAND flash memory, NOR flash memory, and/or the like, flash drives such as SSD, CF card, SD card, Micro-SD card, Mini-SD card, xD card, a memory stick, and/or the like, or storage devices such as HDD.

The cloud server 300 may include a system which provides virtualized server resources accessible through the network 400. The cloud server 300 may remotely execute data storage, processing, and management functions. Through the cloud server 300, a user may use a wide range of computing resources without investment in local hardware.

In one embodiment, the cloud server 300 may receive log data from the battery system 100 through the network 400. The log data may be generated based on detection data of the battery 110. The cloud server 300 may generate a reconstructed (or second) driving scenario based on the log data and transmit the generated log data to the battery system 100. The cloud server 300 may perform battery life prediction simulation based on the reconstructed driving scenario and transmit the generated life prediction value of the battery 110 to the battery system 100.

In one embodiment, the cloud server 300 may include a second communication unit 310, a second processor 320, and a second memory 330.

The second communication unit 310, in conjunction with the network400, may provide a communication interface to provide transmission and reception signals between the battery system 100 and the cloud server 300. The second communication unit 310 may be similar to the first communication unit 131. Thus, a detailed description of the second communication unit 310 will be omitted.

The second processor 320 may control the overall operation of the cloud server 300. The second processor 320 may process a command of a computer program by performing basic arithmetic, logic, and input/output operations.

In one embodiment, the second processor 320 may perform functions such as analyzing log data collected from the battery system 100, reconstructing a driving scenario, and predicting a battery life.

In one embodiment, the second processor 320 may perform at least one of data analysis, processing, and result information generation for performing the functions described above using at least one of machine learning, a neural network, or a deep learning algorithm as a rule-based or artificial intelligence algorithm. Examples of the neural network may include machine learning models such as a convolutional neural network (CNN), a deep neural network (DNN), and a recurrent neural network (RNN). The second processor 320 may be similar to the first processor 132. Thus, a detailed description of the second processor 320 will be omitted.

The second memory 330 may be operably connected to the second processor 320 and may store at least one code associated with an operation performed by the second processor 320. The second memory 330 may perform a function to temporarily or permanently store data processed by the second processor 320. The second memory 330 may be similar to the first memory 133. Thus, a detailed description of the second memory 330will be omitted.

The network 400 may connect the battery system 100 to the cloud server 300. Such a network 400 may include wired networks such as local area networks (LANs), wide area networks (WANs), metropolitan area networks (MANs), integrated service digital networks (ISDNs), and/or the like, or wireless networks such as wireless LANs, code-division multiple access (CDMA), satellite communication, and/or the like, but the scope of the disclosure is not limited thereto. The network 400 may transmit and receive information using short-range communication and/or long-range communication. Short-range communication may include Bluetooth, radio frequency identification (RFID), infrared data association (IrDA), a ultra-wideband (UWB), ZigBee, and Wi-Fi technologies, and long-range communication may include CDMA, frequency-division multiple access (FDMA), time-division multiple access (TDMA), orthogonal frequency-division multiple access (OFDMA), and single carrier frequency-division multiple access (SC-FDMA) technologies.

The network 400 may include connections of network elements such as hubs, bridges, routers, and switches. The network 400 may include one or more connected networks such as a multi-network environment, including a public network such as the Internet, and/or a private network such as a secure corporate private network. Access to the network 400 may be provided via one or more wired or wireless access networks.

In some embodiments, the network 400 may support controller area network (CAN) communication, vehicle to infrastructure (V2I) communication, vehicle to everything (V2X) communication, wireless access in vehicular environment (WAVE) communication, and an Internet of Things (IoT) network, 5G communication, and/or the like, configured to exchange and process information between distributed components such as objects and/or the like

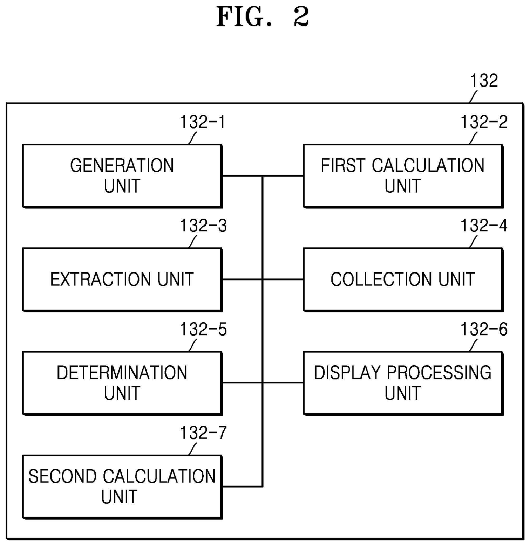

FIG. 2 depicts a block diagram of a first processor provided in a BMS (e.g., the MBS 130) as a battery life prediction apparatus, according to an embodiment of the disclosure. In the following description, parts redundant to the description of FIG. 1 will be omitted.

Referring to FIG. 2, the first processor 132 included in the BMS 130 as a battery life prediction apparatus may include a generation unit 132-1, a first calculation unit 132-2, an extraction unit 132-3, a collection unit 132-4, a determination unit 132-5, a display processing unit 132-6, and a second calculation unit 132-7.

The generation unit 132-1 may generate field data (e.g., acquired data) through event-based profiling based on a detection result of one or more of voltage, current, and temperature collected from the battery of the EV.

The generation unit 132-1 may monitor the voltage, current, temperature, state of charge (SOC), power, and/or the like, (hereinafter, "battery state data") of the battery 110 based on the detection data. The generation unit 132-1 may allow the EV to maintain optimal operating conditions (e.g., operating conditions that satisfy a threshold) based on a monitoring result of the battery state data.

The generation unit 132-1 may estimate an SOC based on the detection data. The BMS 130 may estimate the SOC of the battery 110 by using one or more of a current integration method integrating charging/discharging current, an electrochemical modeling method representing a chemical reaction inside a cell in molecular units, a mathematical method expressing dynamic behaviors of an operating time and SOC of the battery 110 in an empirical formula, and a voltage modeling method using a relationship between an open circuit voltage (OCV) and an SOC.

The generation unit 132-1 may calculate a power of the battery 110 based on the detection data. For example, the BMS 130 may calculate the power of the battery 110 by using a product of the voltage and the current included in the detection data.

The generation unit 132-1 may generate a profile representing a physical quantity or values of factors related to the life of the battery 110 based on the battery state data, and store the profile in the first memory 133. The profile may include a time series profile that represents changes in various factors such as voltage, current, temperature, SOC, and/or the like, over time. The profile may be distinguished or differentiated according to the operating state of the battery 110. The operating state of the battery 110 may be one or more of a rest state, discharging state, and charging state. A battery may be in a discharging state when the EV is in motion (e.g., when the EV travels), and in a rest state when the EV is parked.

The generation unit 132-1 may store a profile generated by measuring an event of factors related to the life of the battery 110 in the form of an event count. The event count format may represent a method of measuring a physical quantity (e.g., an event) to be stored at certain (e.g., regular) time intervals and storing the physical quantity in a corresponding storage. The generation unit 132-1 may determine, as the field data, the profile generated by measuring the factors related to the life of the battery 110 in the form of an event count.

In one embodiment, the battery state data may represent values of factors such as an SOC, a temperature, a charging/discharging rate (C-rate), and/or the like, over time. For example, the battery state data may record over time how much the battery 110 is charged (e.g., the SOC value), the current temperature of the battery 110, and/or the like.

As the field data is generated and stored in the event count format, it may represent the values of factors other than the physical quantity representing time (one or more of voltage, current, temperature, and SOC). For example, data may be recorded when the SOC of the battery 110 reaches a certain threshold level or when the temperature of the battery 110 exceeds a set threshold, but the physical quantity of "time" may not be directly recorded. Instead, the voltage, current, temperature, and SOC at the time the event is detected may be recorded.

The first calculation unit 132-2 may calculate the SOH of the battery 110 using the field data. For example, the first calculation unit 132-2 may integrate the amount of current during change of the SOC of the battery 110 to calculate the SOH of the battery 110.

The first calculation unit 132-2 may integrate current consumed in the battery 110 for an identified (e.g., a preset) time to calculate one or more of discharging energy and charging energy. The first calculation unit 132-2 may calculate an SOC variance which indicates how much the SOC of the battery 110 has decreased or increased for the preset time. The first calculation unit 132-2 may calculate the SOH of the battery 110 by comparing the discharge energy or charge energy with the SOC variance.

For example, the first calculation unit 132-2 may integrate the current consumed in the battery 110 for a time during which the SOC of the battery 110 decreases by 30%, and calculate the discharging energy of the battery 110. By substituting the discharging energy into a mathematical formula (SOC variance : energy variance = 100% : Etotal), a total energy Etotal of the battery 110 may be calculated when the SOC is 100%. The first calculation unit 132-2 may determine an SOH by comparing the total energy Etotal of the battery 110 with a total energy after (e.g., immediately after) shipment of the battery 110. For example, in case that the total energy Etotal of the battery 110 calculated at the current time point using the mathematical formula described above is 0.9 times the total energy immediately after shipment of the battery 110 or the battery system 100 including the battery 110, the SOH of the battery 110 at the current time point may be calculated as 90%.

The extraction unit 132-3 may extract, as the log data, battery performance indicator data corresponding to the operating state of the battery 110 from the field data. In one embodiment, the operating state of the battery 110 may be one or more of a rest state, discharging state, and charging state. The battery 110 may be in a discharging state when the EV is in motion (e.g., when the EV travels), and in a rest state when the EV is parked. In one embodiment, the battery performance indicator data may include cell temperature, cell SOC, power use pattern, energy amount, and/or the like, corresponding to the operating state of the battery 110.

The extraction unit 132-3 may configure a log table based on the battery performance indicator data corresponding to the operating state of the battery 110 from the field data. The extraction unit 132-3 may implement a rest log table using the field data generated based on the battery state data obtained in the rest state of the battery 110. The extraction unit 132-3 may implement a discharging log table using the field data generated based on the battery state data obtained in the discharging state of the battery 110. The extraction unit 132-3 may implement a charging log table using the field data generated based on the battery state data obtained in the charging state of the battery 110.

The extraction unit 132-3 may extract one or more of first to seventh log data to generate the life prediction value of the battery 110 from the rest log table, the charging log table, and the discharging log table.

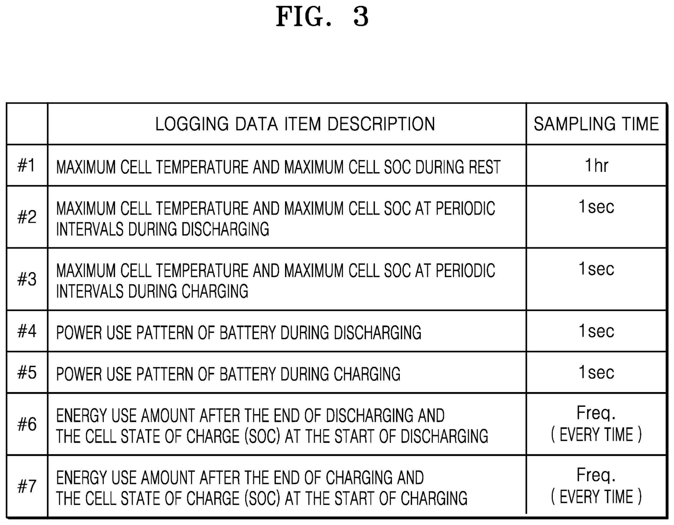

FIG. 3 depicts a table storing log data extracted from field data stored in a battery life prediction apparatus according to an embodiment of the disclosure. In the following description, parts redundant to the description of FIGS. 1 and 2 will be omitted.

Referring to FIG. 3, a first log data may include one or more of the temperature of the battery (e.g., battery cell) 110 and the SOC of the battery (e.g., battery cell) 110 extracted at periodic (e.g., regular or irregular) intervals (e.g., a sampling time of 1 hour) while the battery is at rest.

A second log data may include one or more of the temperature of the battery (e.g., battery cell) 110 and the SOC of the battery (e.g., battery cell) 110 extracted at periodic (e.g., regular or irregular) intervals (e.g., a sampling time of 1 second) during discharging of the battery.

A third log data may include one or more of the temperature of the battery (e.g., battery cell) 110 and the SOC of the battery (e.g., battery cell) 110 extracted at periodic (e.g., regular or irregular) intervals (e.g., a sampling time of 1 second) during charging of the battery.

A fourth log data may include the power use pattern of the battery 110 extracted at periodic (e.g., regular or irregular) intervals (e.g., sampling time of 1 second) during discharging of the battery.

The fifth log data may include the power use pattern of the battery 110 extracted at periodic (e.g., regular or irregular) intervals (e.g., sampling time of 1 second) during charging of the battery.

The sixth log data may include one or more of the energy use amount of the battery (e.g., battery cell) 110 extracted at periodic (e.g., regular or irregular) intervals (e.g., a sampling time of every time) after the end of discharging and the SOC of the battery (e.g., battery cell) 110 at the start of discharging of the battery.

The seventh log data may include one or more of the energy use amount of the battery (e.g., battery cell) 110 extracted at periodic (e.g., regular or irregular) intervals (e.g., a sampling time of every time) after the end of charging of the battery and the SOC of the battery (e.g., battery cell) 110 at the start of charging of the battery.

Returning to FIG. 2, the collection unit 132-4 may transmit one or more of the first to seventh log data to the cloud server 300, and the cloud server 300 may collect or identify the life prediction value of the battery 110 generated based on one or more of the first to seventh log data from the cloud server 300.

In some embodiments, the collection unit 132-4 may collect or receive the life prediction value of the battery 110 from the cloud server 300 as the cloud server 300 selects, as an operation pattern of an identified (e.g., a preset) period for an EV based on the log data, one or more scenario pattern templates among a first scenario pattern template, a second scenario pattern template, and a third scenario pattern template. The cloud server 300 may generate a driving scenario of an identified (e.g., a preset) period including one or more of a discharging section, a charging section, and a rest section of the selected scenario pattern template, and sample (e.g., randomly sample) a physical quantity from the log data to generate a reconstructed driving scenario corresponding to the driving scenario of the preset period. In some embodiments, the cloud server 300 may apply a Monte-Carlo simulation method to the reconstructed driving scenario to reconstruct an identified (e.g., a preset) number of reconstructed driving scenarios, simulate driving of the EV as a result of reconstruction of the identified number of reconstructed driving scenarios to calculate a battery capacity with respect to time, and generate the life prediction value of the battery 110 based on the battery capacity with respect to time.

In view of the collection unit 132-4, the cloud server 300 may collect data generated by the cloud server 300, (e.g., the life prediction value of the battery 110). In some embodiments, an entity generating the life prediction value of the battery 110 may be the cloud server 300. Thus, for convenience, in the following description, a process of generating the life prediction value of the battery 110 using the cloud server 300 as the entity will be described. The second processor 320 included in the cloud server 300 may generate the reconstructed driving scenario and the life prediction value of the battery 110.

The cloud server 300 may select the operation pattern for the EV for an identified (e.g., a preset) period (e.g., 30 days) based on one or more of the first to seventh log data, as one or more of the first scenario pattern template, the second scenario pattern template, and the third scenario pattern template. In one embodiment, the cloud server 300 may select one or more scenario pattern templates based on a ratio of the sixth log data and the seventh log data. In one embodiment, a template may refer to a profile of a graph that depicts the SOC of the battery (e.g., battery cell) 110 with respect to time is diagrammed.

In one embodiment, the first scenario pattern template may include a case where charging and discharging of the battery (e.g., battery cell) 110 is at a ratio of 1:1. The first scenario pattern template may be selected for case where the EV is driven once a day with one charging per day. The first scenario pattern template may be referred to as a family use template.

In one embodiment, the second scenario pattern template may include a case where charging and discharging of the battery (e.g., battery cell) 110 is at a ratio of 1:2. For example, the second scenario pattern template may be selected for a case where the EV is driven twice a day with one charging per day. The second scenario pattern template may apply, for example, to cases where the EV is used for commuting to and from work. The second scenario pattern template may be referred to as an office commute template.

In one embodiment, the third scenario pattern template may include a mix of the first scenario pattern template and the second scenario pattern template. The third scenario pattern template may be depict a case where the first scenario pattern template and the second scenario pattern template are mixed at a charging/discharging ratio.

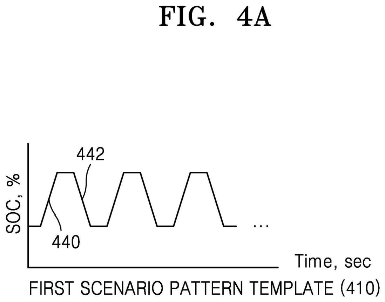

FIGS. 4A-4C of depict graphs of the SOC of a battery over time for respectively the first, second, and third scenario pattern templates for battery life prediction according to an embodiment of the disclosure. In the following description, parts redundant to the description of FIGS. 1 to 3 will be omitted.

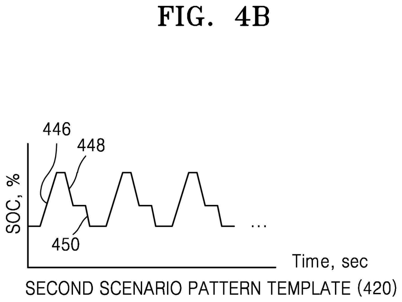

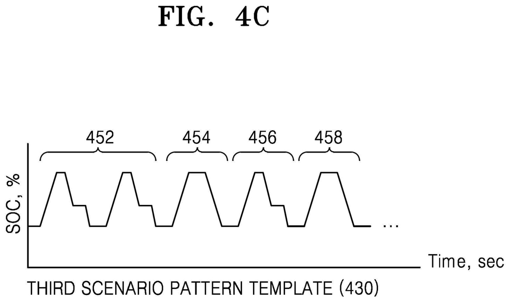

Referring to FIG. 4, in the first scenario pattern template 410, the SOC of the battery increases 440 as the battery is in a charging state, and decreases 442 as the battery is in a discharging state (e.g., when the EV is in motion). The pattern may repeat, for example, once a day.

In the second scenario template 420, the charging of the battery occurs once a day, but the discharging occurs twice a day. The SCO of the battery increases 446 during the charging state, and decreases 448, 450 during the first and second discharge periods. The pattern may repeat, for example, once a day.

In the third scenario template 430, either one of the first scenario pattern or the second scenario pattern occurs on a particular day. For example, in the example of FIG. 4C, the second scenario pattern occurs on two consecutive days 452, followed by the first scenario pattern on the third day 454, the second scenario pattern on a fourth day 456, and the first scenario patter on the fifth day.

The cloud server 300 may generate the driving scenario of the preset period including one or more of the discharge section, the charging section, and the rest section based on the selected scenario pattern template.

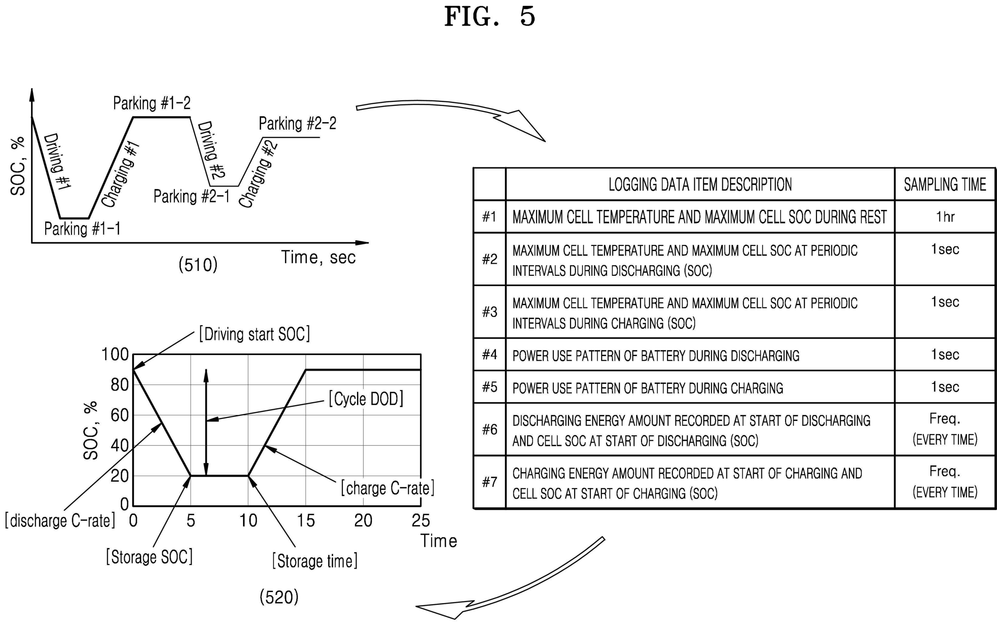

FIG. 5 depicts a graph of a state of charge (SOC) of a battery SOC over time for a driving scenario reconstructed using log data according to an embodiment of the disclosure. In the following description, parts redundant to the description of FIGS. 1 to 4 will be omitted.

Referring to FIG. 5, a driving scenario 510 may be generated by the cloud server 300 based on the selected scenario pattern template. The driving scenario 510 may be generated, for example, based on the first scenario pattern template 410. For example, the cloud server 300 may calculate a charge/discharge ratio for each cycle based on the frequency of charging/discharging and the amount of energy used, extracted from the sixth and seventh log data. If the average number of discharges per single charge is 1.0 or less, a "Family use Template" (e.g., the first scenario pattern template) may be selected. If the number is 2.0 or more, an "Office commute Template" (e.g., a second scenario pattern template) may be selected. If the number is between the 1.0 and 2.0, a "Combined Template" (e.g., a third scenario pattern template) may be selected.

The driving scenario 510 may include a discharging section Driving #1, a resting section Parking #1-1, a charging section Charging #1, a resting section Parking #1-2, a discharging section Driving #2, a resting section Parking #2-1, a charging section Charging #2, a resting section Parking #2-2, etc.

The cloud server 300 may sample (e.g., randomly sample) the required physical quantity from the first to seventh log data to generate a reconstructed driving scenario 520 (e.g., a reconstructed driving scenario graph) corresponding to the driving scenario 510 of the preset period.

Referring to FIG. 5, in some embodiments, the cloud server 300 generates the reconstructed driving scenario 520 by sampling (e.g., randomly sampling) the physical quantity based on the first to seventh log data shown in FIG. 3.

The reconstructed driving scenario 520 may include one or more of an SOC at the start of discharging, a battery discharging rate, an SOC at the time of rest, a battery rest time, a battery charging rate, and a battery discharging depth cycle, which are extracted or calculated from one or more of the first to seventh log data, corresponding to one or more of the discharge section, the charge section, and the rest section included in the driving scenario 510.

The cloud server 300 may extract the SOC at the start of discharging (referenced as Driving start SOC) from the sixth log data. In one embodiment, as the sixth log data includes the SOC at the start of discharging, the SOC at the start of discharging (Driving start SOC) may be extracted from the sixth log data.

The cloud server 300 may calculate the battery discharging rate (referenced as Discharge C-rate) based on the fourth log data and the sixth log data. To calculate the battery discharging rate Cycle discharge C-rate, the cloud server 300 may calculate the total discharging energy used by the EV while driving using the sixth log data. The total discharging energy may be calculated by dividing a difference between the SOC at the start of discharging and the SOC at the end of discharging by 100 and multiplying a result of the dividing by the capacity of the battery 110 ((SOC at the start of discharging - SOC at the end of discharging)/100) × capacity of the battery 110). The cloud server 300 may calculate the total driving time of the EV based on the fourth log data. The fourth log data may include one or more of a discharging start time and a discharging end time because the fourth log data includes a battery power use pattern extracted at periodic intervals (every second) during discharging. The total driving time may be calculated by calculating a difference between the discharging start time and the discharging end time included in the fourth log data. The cloud server 300 may calculate the battery discharging rate Cycle (discharge C-rate) by dividing the total discharging energy by the total driving time.

The cloud server 300 may extract the SOC at the time of rest (referenced as Storage SOC) from the first log data. In one embodiment, as the first log data includes the SOC during rest, the SOC at the time of rest (Storage SOC) may be extracted from the first log data.

The cloud server 300 may calculate a battery rest time (referenced as Storage time) based on the sixth log data and the seventh log data. The cloud server 300 may calculate one or more of the discharging time and the charging time from the sixth log data and the seventh log data. The discharging time may be calculated as a time from a discharging start SOC to a discharging end SOC. The charging time may be calculated as a time from a charging start SOC to a charging end SOC. The cloud server 300 may calculate a battery storage time by excluding the remaining time except for the discharging time and the charging time from the total driving time described above.

The cloud server 300 may calculate the battery charging rate charge C-rate based on the fifth log data. The fifth log data may include a battery a power use pattern extracted at periodic intervals during charging and may be collected when the EV is charged via an external charger (not shown). It may be assumed that power supplied from the external charger is constant during charging. The cloud server 300 may randomly sample 1-hour data, i.e., 3600 data points, from the fifth log data and calculate a sum of power values of the sampled data points. The cloud server 300 may calculate the battery charging rate Charge C-rate by dividing the total sum of the power values by the total capacity of the battery 110.

The cloud server 300 may calculate a battery discharging depth cycle depth of discharging (DOD) based on the sixth log data and the seventh log data. To calculate the battery discharging depth cycle DOD, the cloud server 300 may extract the battery SOC at the start of discharging from the sixth log data. The cloud server 300 may extract (e.g., randomly extract) the SOC at the start of charging, which is lower than the SOC at the start of discharging, from the seventh log data. The cloud server 300 may calculate the difference between the battery SOC at the start of discharging and the SOC at the start of charging as the battery discharging depth cycle DOD.

The cloud server 300 may generate an identified (e.g., a preset) number of reconstructed driving scenarios by applying the Monte-Carlo simulation method to the reconstructed driving scenario.

The field data may not include a physical quantity representing a time in a process of analyzing an event related to the life of the battery 110 through profiling. In this way, by supplementing lost time information from the field data, the cloud server 300 may use the Monte-Carlo simulation method to provide a reconstructed driving scenario of the preset period that may cover various cases.

The cloud server 300 may generate an identified (e.g., a preset) number of reconstructed driving scenarios for the preset period. The preset number may include a sufficient (e.g., a threshold) number to cover various cases through the reconstructed driving scenarios. In this regard, a first reconstructed driving scenario may be based on sampling log data (e.g., the first to seventh log data) associated with a first time period in the preset period, and a second reconstructed driving scenario may be based on sampling log data (e.g., the first to seventh log data) associated with a second time period in the preset period that is at least partially different form the first time period.

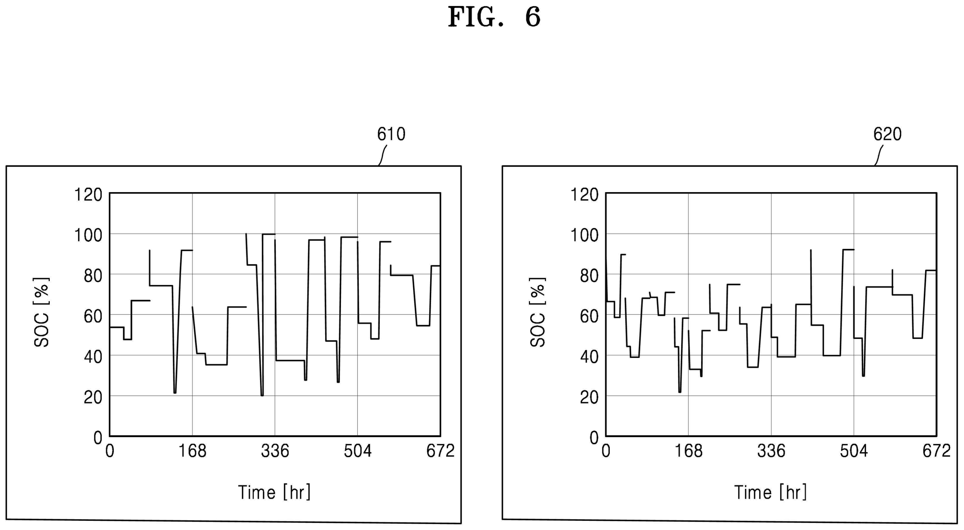

FIGS. 6A-6B are graphs of a state of charge of a battery over time for respectively a first case (e.g., a worst case) 610 and a second case (e.g., a best case) 620 among the results of restoring an identified (e.g., a preset) number of reconstructed driving scenarios of an identified (e.g., a preset) period according to an embodiment of the disclosure. In the following description, parts redundant to the description of FIGS. 1 to 5 will be omitted.

In the example of FIGS. 6A-6B, the preset period for which reconstructed driving scenarios are created is 1 month. The worst case 610 may include a combination of first value (e.g., high) battery depth of discharging cycle (Cycle DOD), second value (e.g., high) battery charging/discharging rate (C-rate), and third value (e.g., worst) temperature conditions.

The best case 620 among the results of restoring an identified (e.g., a preset) number of reconstructed driving scenarios of the preset period may include a combination of fourth value (e.g., low) battery depth of discharging cycle (Cycle DOD), fifth value (e.g., low) battery charging/discharging rate (C-rate), and sixth value (e.g., best) temperature conditions.

As the reconstructed driving scenario is established by extracting the physical quantity from the field data in one embodiment, there may be no continuity in SOC, unlike the original pattern of the SOC over time.

The cloud server 300 may simulate the operation of the EV using the results of restoring an identified (e.g., a preset) number of reconstructed driving scenarios to calculate the battery capacity over time. In one embodiment, the cloud server 300 may simulate the operation of the EV more than 300 times with an identified (e.g., a preset) number of generated reconstructed driving scenarios.

In one embodiment, the battery capacity over time may include a monitoring result for SOC change. The cloud server 300 may calculate the battery capacity over time by monitoring how quickly and deeply the battery 110 is discharged and how the battery 110 is charged, in a reconfigured driving scenario during simulation.

The cloud server 300 may generate the life prediction value of the battery 110 based on the battery capacity over time. The cloud server 300 may generate the life prediction value of the battery 110 corresponding to the battery capacity over time by simulating the operation of the EV using a deep neural network model that is pre-trained to generate the life prediction value of the battery based on the battery capacity over time. The deep neural network model may be a model trained in a supervised learning manner using training data having the battery capacity over time as an input and the life prediction value of the battery as a label.

The cloud server 300 may train an initially configured deep neural network model using the labeled training data in the supervised learning manner. The initially set machine learning model may be an initial model designed to be configured as a model capable of generating the life prediction value of the battery based on the battery capacity over time, and parameter values may be set to initial values (e.g., random initial values). The parameter values may be optimized as the initial model is trained using the training data described above, such that the initial model may be completed as a generative model capable of generating the life prediction value of the battery based on the battery capacity over time.

The cloud server 300 may transmit the generated life prediction value of the battery to the collection unit 132-4. In one embodiment, the cloud server 300 may transmit data processed to generate the life prediction value of the battery, such as a reconstructed driving scenario, and/or the like, to the collection unit 132-4 as well as the life prediction value of the battery.

Returning to FIG. 2, the determination unit 132-5 may determine whether the life of the battery 110 is abnormal, by comparing the SOH of the battery 110 calculated by the first calculation unit 132-2 with the life prediction value of the battery 110 collected from the cloud server 300. The determination unit 132-5 may determine that the life of the battery 110 is abnormal based on the difference between the SOH of the battery 110 and the life prediction value of the battery 110 being at least a reference value.

The life prediction value of the battery 110 collected from the cloud server 300 may be generated by performing simulation 300 or more times, and may include 300 or more life prediction values. The determination unit 132-5 may generate a graph based on 300 or more life prediction values. The determination unit 132-5 may draw the SOH of the battery 110 calculated by the first calculation unit 132-2 on the graph.

The determination unit 132-5 may determine that the life of the battery 110 is normal as the result of drawing the SOH of the battery 110 is within a distribution range of the graph. The determination unit 132-5 may determine that the life of the battery 110 is abnormal as the result of drawing the SOH of the battery 110 is out of the distribution range of the graph.

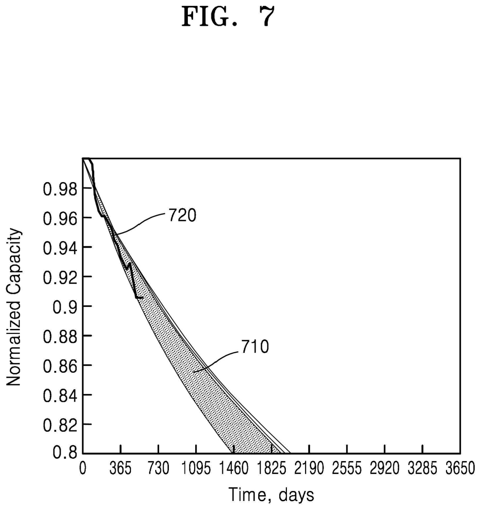

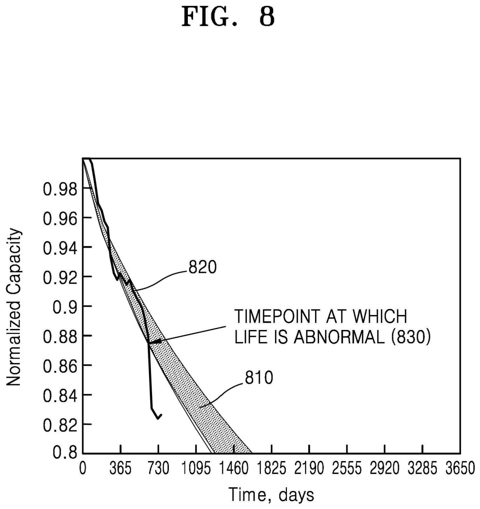

FIGS. 7 and 8 are examples of graphs comparing an SOH of a battery and a life prediction value of the battery according to an embodiment of the disclosure. In the following description, parts redundant to the description of FIGS. 1 to 6 will be omitted.

Referring to FIG. 7, a graph 710 using the life prediction value of the battery 110 collected from the cloud server 300 is generated as an example. In FIG. 7, a result 720 of drawing the SOH of the battery 110 calculated by the first calculation unit 132-2 on the graph is shown. It may be determined from FIG. 7 that the life of the battery 110 is normal as the result 720 of drawing the SOH of the battery 110 being within the distribution range of the graph 710.

Referring to FIG. 8, a graph 810 using the life prediction value of the battery 110 collected from the cloud server 300 is generated as an example. In FIG. 8, a result 820 of drawing the SOH of the battery 110 calculated by the first calculation unit 132-2 on the graph is shown. It may be determined from FIG. 8 that the life of the battery 110 is normal as the result 820 of drawing the SOH of the battery 110 being within the distribution range of the graph. In some embodiments, a timepoint 830 when the result 820 of drawing the SOH of the battery 110 is out of the distribution range of the graph may be a timepoint when the life of the battery 110 is abnormal.

The display processing unit 132-6 may receive a result of whether the life of battery 110 is abnormal from the determination unit 132-5 and output the result to the display unit 200 of the EV. As the display processing unit 132-6 receives, from the determination unit 132-5, a result indicating that the life of the battery 110 is abnormal, the display processing unit 132-6 may output an alert signal or notification through the display unit 200. The display processing unit 132-6 may process the alert signal or notification in various forms such as graphics, text, icons, and/or the like, and output the same to the display unit 200. Such an operation of the display processing unit 132-6 may help a driver to understand the state of the EV and making an appropriate driving decision. In one embodiment, outputting the alert signal or notification through the display unit 200 may include informing a user of the result indicating whether the life of the battery 110 is abnormal.

The second calculation unit 132-7 may calculate the RUL of the battery 110 based on the SOH of the battery 110 calculated by the first calculation unit 132-2 and the life prediction value of the battery 110 collected from the cloud server 300.

The second calculation unit 132-7 may calculate a difference between a first value and a second value as the RUL of the battery 110. The first value may include the SOH of the battery 110 calculated by the first calculating unit 132-2. The second value may include an average value for the life prediction value of the battery 110.

The display processing unit 132-6 may receive the RUL of the battery 110 from the second calculation unit 132-7 and output the RUL to the display unit 200 of the EV. In one embodiment, outputting the RUL of the battery 110 through the display unit 200 may include informing the user of the RUL of the battery 110.

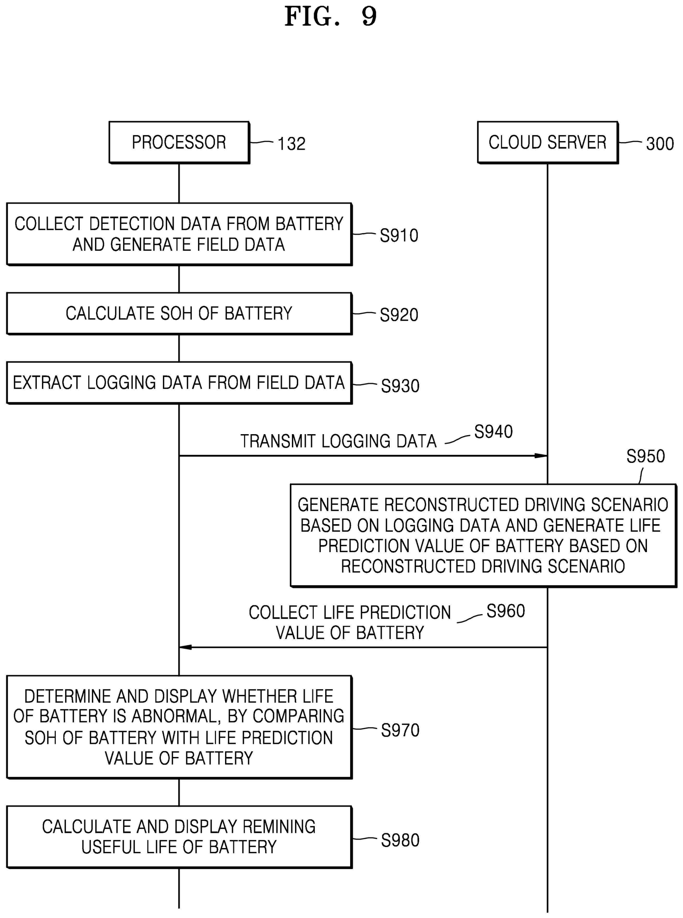

FIG. 9 is a flowchart of a battery life prediction method according to an embodiment of the disclosure. In the following description, parts redundant to the description of FIGS. 1 to 8 will be omitted. The description will be made assuming that the battery life prediction method according to one embodiment is performed by the BMS 130 as the battery life prediction apparatus with the help of peripheral components.

Referring to FIG. 9, in operation S910, the first processor 132 may generate field data through event-based profiling based on one or more detection results of voltage, current, and temperature collected from a battery 110 of the EV. In one embodiment, the first processor 132 may collect detection data including one or more of voltage, current, and temperature from the battery in generating the field data. The first processor 132 may estimate the SOC of the battery 110 using the detection data and calculate the power of the battery 110. The first processor 132 may determine, as the field data, a profile generated by measuring a physical state of the battery 110 in an event count format based on battery state data including the detection data, the SOC, and the power.

In operation S920, the first processor 132 may calculate the SOH of the battery 110 using the field data. The first processor 132 may integrate the amount of current during change of the SOC of the battery 110 to calculate the SOH of the battery 110.

In operation S930, the first processor 132 may extract, as the log data, battery performance indicator data corresponding to the operating state of the battery 110 from the field data. In one embodiment, the first processor 132 may extract battery performance indicator data corresponding to the operating state of the battery 110, including at least one of a rest state, discharging state, and charging state, from the field data as one or more of the first to seventh log data, in extracting the log data. In one embodiment, the first log data may include one or more of the temperature and SOC of the battery 110 extracted at periodic intervals during rest. The second log data may include one or more of the temperature and SOC of the battery 110 extracted at periodic intervals during discharging. The third log data may include one or more of the temperature and SOC of the battery 110 extracted at periodic intervals during charging. The fourth log data may include a battery power use pattern extracted at periodic intervals during discharging. The fifth log data may include a battery power use pattern extracted at periodic intervals during charging. The sixth log data may include one or more of the energy use amount of the battery 110 extracted at periodic intervals after the end of discharging and the SOC at the start of discharging. The seventh log data may include one or more of the energy use amount of the battery 110 extracted at periodic intervals after the end of charging and the SOC at the start of charging.

In operations S940 to S960, the first processor 132 may transmit one or more of the first to seventh log data to the cloud server 300, and the cloud server 300 may collect the life prediction value of the battery 110 generated based on one or more of the first to seventh log data from the cloud server 300. In one embodiment, the first processor 132 may collect the life prediction value of the battery 110 from the cloud server 300 as the cloud server 300 selects, as an operation pattern of an identified (e.g., a preset) period for an EV based on log data, one or more scenario pattern templates among a first scenario pattern template, a second scenario pattern template, and a third scenario pattern template, generate a driving scenario of an identified (e.g., a preset) period including one or more of a discharging section, a charging section, and a rest section from a selected scenario pattern template of the one or more scenario pattern templates, sample (e.g., randomly sample) one or more physical quantities from the log data to generate a reconstructed driving scenario corresponding to the driving scenario of the preset period, apply a Monte-Carlo simulation method to the reconstructed driving scenario to reconstruct an identified (e.g., a preset) number of reconstructed driving scenarios, simulate driving of the EV as a result of reconstruction of an identified (e.g., a preset) number of reconstructed driving scenarios to calculate a battery capacity with respect to time, and generate the life prediction value of the battery 110 based on the battery capacity with respect to time. In one embodiment, the reconstructed driving scenario may include one or more of an SOC at the start of discharging, a battery discharging rate, an SOC at the time of rest, a battery rest time, a battery charging rate, and a battery discharging depth cycle, which are extracted or calculated by the cloud server 300 from the log data, corresponding to one or more of the discharge section, the charge section, and the rest section included in the driving scenario. In one embodiment, the SOC at the start of discharging may be extracted by the cloud server 300 from the sixth log data including one or more of the energy use amount of the battery 110, extracted at periodic intervals after the end of discharging, and the SOC at the start of discharging. In one embodiment, the battery discharging rate may be calculated based on the fourth log data and the sixth log data including the battery power use pattern extracted at periodic intervals during discharging among the log data by the cloud server 300. In one embodiment, the SOC at the time of rest may be extracted by the cloud server 300 from the first log data including one or more of the temperature and SOC of the battery 110, extracted at periodic intervals during rest, among the log data. In one embodiment, the battery rest time may be calculated by the cloud server 300 based on one or more of the sixth log data and the seventh log data including the energy use amount of the battery 110 extracted at periodic intervals after the end of charging and the SOC at the start of charging, among the log data. In one embodiment, the battery charging rate may be calculated by the cloud server 300 based on the fifth log data including the battery power use pattern extracted at periodic intervals during charging among the log data. In one embodiment, the battery discharging depth cycle may be calculated by the cloud server 300 based on one or more of the sixth log data and the seventh log data among the log data. In one embodiment, when the life prediction value of the battery 110 is generated by the cloud server 300, the deep neural network model that is pre-trained to generate the life prediction value of the battery based on the battery capacity over time may be used to simulate driving of the EV, thereby generating the life prediction value of the battery 110 corresponding to the calculated battery capacity over time. The deep neural network model may be a model trained in a supervised learning manner using training data having the battery capacity over time as an input and the life prediction value of the battery as a label.

In operation S970, the first processor 132 may determine whether the life of the battery 110 is abnormal, by comparing the SOH of the battery 110 with the life prediction value of the battery 110 collected from the cloud server 300, and display the determination result on the display unit 200. The first processor 132 may determine that the life of the battery 110 is abnormal in case that the difference between the SOH of the battery 110 and the life prediction value of the battery 110 is at least a reference value.

In operation S980, the first processor 132 may calculate the difference between the first value and the second value as the RUL of the battery 110 and display the RUL on the display unit 200. The first value may include the SOH of the battery 110, and the second value may include an average value for the life prediction value of the battery 110.

According to the disclosure, by utilizing data processing and analysis over a cloud, the BMS may more accurately predict the life of the battery, thereby significantly helping battery performance management and replacement timing determination.

It may be possible to overcome the limitations of data logging and analysis previously limited due to limited memory and processing capabilities, and enables more in-depth battery state analysis based on rich data.

While the disclosure is described by limited embodiments and drawings, the disclosure is not limited thereby and various modifications and changes may be made by those of ordinary skill in the art within the scope of the disclosure and the equivalent range to the claims set forth below.

## Claims

1. A battery life prediction method comprising:
generating, by a processor, field data through event-based profiling based on one or more detection results of voltage, current, and temperature collected from a battery;
calculating, by the processor, a state of health (SOH) of the battery using the field data;
extracting, by the processor, as log data, battery performance indicator data corresponding to an operating state of the battery from the field data;
transmitting, by the processor, the log data to a server and receiving a life prediction value of the battery generated by the server based on the log data;
determining status related to the life of the battery based on comparing the SOH of the battery with the life prediction value of the battery; and
performing an action with respect to the battery based on determining the status.

2. The battery life prediction method of claim 1, wherein the generating of the field data comprises:
collecting detection data comprising one or more of voltage, current, and temperature from the battery;
estimating a state of charge (SOC) of the battery using the detection data and calculating a power of the battery; and
determining, as the field data, a profile generated by measuring a physical state of the battery in an event count format based on battery state data comprising one or more of the detection data, the SOC, and the power.

3. The battery life prediction method of claim 1 or claim 2, wherein the extracting as the log data comprises extracting, as one or more of first log data to seventh log data, the battery performance indicator data corresponding to the operating state of the battery, comprising one or more of a rest state, discharging state, and charging state, from the field data, and
the first log data comprises one or more of the temperature and state of charge (SOC) of the battery extracted at one or more first intervals during the rest state,
the second log data comprises one or more of the temperature and the SOC of the battery extracted at one or more second intervals during the discharging state,
the third log data comprises one or more of the temperature and the SOC of the battery extracted at one or more third intervals during the charging state,
the fourth log data comprises a battery power use pattern extracted at one or more fourth intervals during the discharging state,
the fifth log data comprises a battery power use pattern extracted at one or more fifth intervals during the charging state,
the sixth log data comprises one or more of an energy use amount of the battery extracted at one or more sixth intervals after end of the discharging state and the SOC at start of the discharging state, and
the seventh log data comprises one or more of the energy use amount of the battery extracted at one or more seventh intervals after end of the charging state and the SOC at start of the charging state.

4. The battery life prediction method of any preceding claim, wherein the collecting of the life prediction value from the server comprises:
selecting, by the server, an operating pattern for an electric vehicle for a first period from one or more of a first scenario pattern template, a second scenario pattern template, and a third scenario pattern template, based on the log data,
generating, by the server, a first driving scenario of the first period comprising one or more of a discharge section, a charging section, and a rest section based on the operating pattern selected by the server;
generating, by the server, a second driving scenario corresponding to the first driving scenario of the first period by sampling a one or more physical quantities from the log data;
generating, by the server, one or more of the second driving scenarios;
simulating, by the server, an operation of the electric vehicle based on simulating of the one or more second driving scenarios to calculate a battery capacity over time; and
identifying, by the server, the life prediction value of the battery based on the server generating the life prediction value of the battery based on the battery capacity over time.

5. The battery life prediction method of claim 4, wherein the second driving scenario comprises one or more of a first state of charge (SOC) at a start of battery discharging, a battery discharging rate, a second SOC at a time of rest, a battery rest time, a battery charging rate, and a battery discharging depth cycle, which are extracted or calculated from the log data, corresponding to one or more of the discharging section, the charging section, and the rest section included in the driving scenario.

6. The battery life prediction method of claim 5, wherein the first SOC at the start of discharging is extracted from sixth log data comprising one or more of an energy use amount of the battery, extracted at one or more first intervals after end of discharging, and the first SOC at the start of discharging, among the log data,
the battery discharging rate is calculated based on fourth log data and the sixth log data, the fourth log data comprising a battery power use pattern extracted at one or more second intervals during discharging, from the log data,
the second SOC at the time of rest is extracted from first log data comprising one or more of temperature and the second SOC of the battery, extracted at periodic intervals during rest, among the log data,
the battery rest time is calculated based on one or more of the sixth log data and seventh log data comprising one or more of the energy use amount of the battery extracted at one or more third intervals after end of charging, and third SOC at a start of charging,
the battery charging rate is calculated based on fifth log data comprising a battery power use pattern extracted at one or more fourth intervals during charging, from the log data, and
the battery discharging depth cycle is calculated based on one or more of the sixth log data and the seventh log data among the log data.

7. The battery life prediction method of any one of claims 4 - 6, wherein the battery capacity over time is calculated by simulating operation of the electric vehicle using a deep neural network model that is pre-trained to generate the life prediction value of the battery based on the battery capacity over time, and
the deep neural network model comprises a model trained in a supervised learning manner using training data having the battery capacity over time as an input and the life prediction value of the battery as a label.

8. The battery life prediction method of any preceding claim, wherein the status is indicative of the life of the battery being abnormal, the method further comprising, after determining that the life of the battery is abnormal, informing a user that the life of the battery is abnormal.

9. The battery life prediction method of any preceding claim, wherein the status is indicative of the life of the battery being abnormal, the method further comprising, after determining that the life of the battery is abnormal, calculating a difference between a first value and a second value as a remaining useful life of the battery and informing a user of the remaining useful life,
wherein the first value comprises a state of health (SOH) of the battery, and
the second value comprises an average value for the life prediction value of the battery.

10. A computer-readable recording medium having stored therein a computer program for executing the battery life prediction method of any preceding claim using a computer.

11. A battery life prediction apparatus comprising:
a processor; and
a memory operatively connected to the processor and storing at least one code to be executed by the processor,
wherein the memory stores a code causing, when executed through the processor, the processor to:
generate field data through event-based profiling based on one or more detection results of voltage, current, and temperature collected from a battery;
calculate a state of health (SOH) of the battery using the field data;
extract, as log data, battery performance indicator data corresponding to an operating state of the battery from the field data;
transmit the log data to a server and receive a life prediction value of the battery generated by server based on the log data;
determine status related to the life of the battery based on comparing the SOH of the battery with the life prediction value of the battery; and
perform an action with respect to the battery based on determining the status.

12. The battery life prediction apparatus of claim 11, wherein the memory stores a code causing the processor to, in generating the field data,
collect detection data comprising one or more of voltage, current, and temperature from the battery,
estimate a state of charge (SOC) of the battery using the detection data and calculate a power of the battery, and
determine, as the field data, a profile generated by measuring a physical state of the battery in an event count format based on battery state data comprising one or more of the detection data, the SOC, and the power.

13. The battery life prediction apparatus of claim 11 or claim 12, wherein the memory stores a code causing the processor to, in extracting as the log data, extract, as one or more of first log data to seventh log data, the battery performance indicator data corresponding to the operating state of the battery, comprising one or more of a rest state, discharging state, and charging state, from the field data, and
the first log data comprises one or more of the temperature and state of charge (SOC) of the battery extracted at one or more first intervals during the rest state,
the second log data comprises one or more of the temperature and the SOC of the battery extracted at one or more second intervals during the discharging state,
the third log data comprises one or more of the temperature and the SOC of the battery extracted at one or more third intervals during the charging state,
the fourth log data comprises a battery power use pattern extracted at one or more fourth intervals during the discharging state,
the fifth log data comprises a battery power use pattern extracted at one or more fifth intervals during the charging state,
the sixth log data comprises one or more of an energy use amount of the battery extracted at one or more sixth intervals after end of the discharging state and the SOC at start of the discharging state, and
the seventh log data comprises one or more of the energy use amount of the battery extracted at one or more seventh intervals after end of the charging state and the SOC at start of the charging state.

14. The battery life prediction apparatus of any one of claims 11 - 13, wherein the memory stores a code causing the processor to, in collecting from the server, allow
the server to select an operating pattern for an electric vehicle for a first period from one or more of a first scenario pattern template, a second scenario pattern template, and a third scenario pattern template, based on the log data;
the server to generate a first driving scenario of the first period comprising one or more of a discharge section, a charging section, and a rest section based on the operating pattern selected by the server;
the server to generate a second driving scenario corresponding to the first driving scenario of the first period by sampling one or more physical quantities from the log data;
the server to generate one or more of the second driving scenarios;
the server to simulate an operation of the electric vehicle based on simulating of the one or more second driving scenarios to calculate a battery capacity over time; and
the server to identify the life prediction value of the battery based on the server generating the life prediction value of the battery based on the battery capacity over time by the server.

15. The battery life prediction apparatus of claim 14, wherein the second driving scenario comprises one or more of a first state of charge (SOC) at a start of battery discharging, a battery discharging rate, a second SOC at a time of rest, a battery rest time, a battery charging rate, and a battery discharging depth cycle, which are extracted or calculated from the log data corresponding to one or more of the discharging section, the charging section, and the rest section included in the driving scenario.
